# EUROPEAN PATENT APPLICATION

(11) **EP 2 151 862 A1**
(43) Date of publication of application: **10.02.2010**
(21) Application number: 08752712.3
(22) Date of filing: 14.05.2008
(51) Int. Cl.: H01L 23/12, G02F 1/1345, G09F 9/00

(54) **SEMICONDUCTOR DEVICE AND ITS MANUFACTURING METHOD, AND DISPLAY AND ITS MANUFACTURING METHOD**

(30) Priority: 30.05.2007 JP 2007142919; 20.09.2007 JP 2007243306
(71) Applicant: Shindo Company, Ltd., Tokyo 130-0015 (JP)
(72) Inventor: RYUTANI, Katsuhiro, Kashiwa-shi Chiba 270-1443 (JP)
(74) Representative: Schwabe - Sandmair - Marx
(86) International application number: PCT/JP2008/058841
(87) International publication number: WO 2008/146603

(57) **Abstract**

A semiconductor device in which a semiconductor has good heat dissipation efficiency, a display employing such a semiconductor device and a method for manufacturing a semiconductor device. A conductive pattern providing a semiconductor-connecting terminal portion and further providing first and second external-connection terminal portion on the opposite sides of the semiconductor-connecting terminal portion is formed on the surface of a flexible insulating substrate to produce a flexible printed wiring board on which a semiconductor is mounted and connected with the semiconductor-connecting terminal portion in the conductive pattern. In such a semiconductor device, a slit is formed in the insulating substrate to surround the semiconductor while leaving a part around the semiconductor thus providing a semiconductor holding part. The insulating substrate is turned down such that the surface comes inside excepting the semiconductor holding part, and the slit is formed such that the mounted semiconductor projects from the backside of the insulating substrate to the outside when the first and second external-connection terminal portion are connected, respectively, with other components.

## Description

### TECHNICAL FIELD

The present invention relates to a semiconductor device having a conductive pattern formed on a front face of its flexible insulating substrate, and a semiconductor connected with the conductive pattern and mounted on the front face of the insulating substrate, and a manufacturing method thereof. In addition, it relates to a display device with such semiconductor device mounted thereon, and a manufacturing method thereof.

### BACKGROUND ART

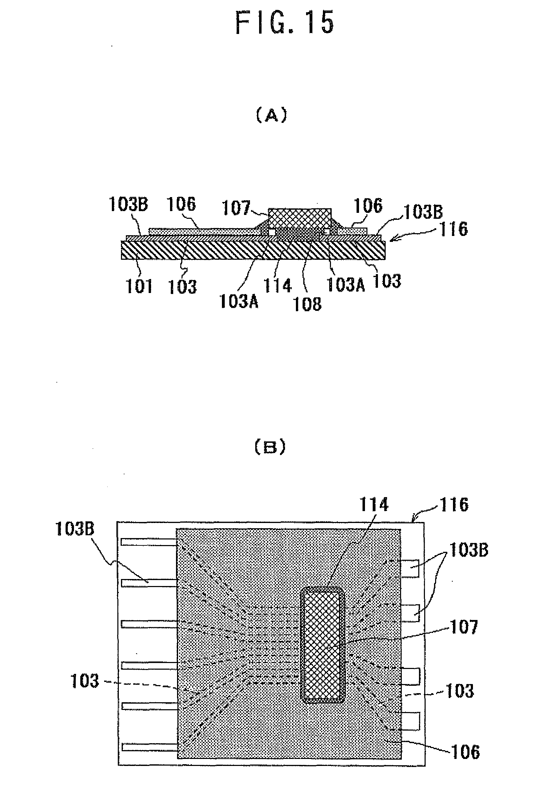

FIGs. 15A and 15B show a conventional semiconductor device.
As to the semiconductor device 116, a conductive pattern 103 is formed on a front face of a film-shaped insulating substrate 101, and a solder resist 106 with a superior flexibility is provided on a predetermined area of the conductive pattern 103 except a terminal portion 103A for connecting a semiconductor and a terminal portion 103B for external connection. The terminal portion 103A of the conductive pattern 103 for connecting a semiconductor is connected with a gold bump 108 provided on a semiconductor 107. The flip chip mounting is adopted therefor, and the semiconductor 107 is mounted on the insulating substrate 101. Then, a sealing resin 114 is charged into between the insulating substrate 101 and semiconductor 107, and cured by heating, thereby sealing in the semiconductor 107 with the resin.

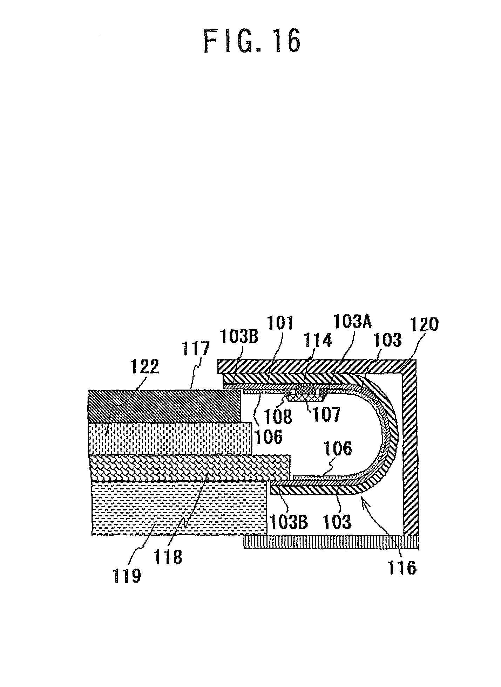

Figure 16 shows an example of using the semiconductor device shown in FIGs. 15A and 15B.
As shown in the drawing, the semiconductor device 116 is assembled by being curved so that the front face of the insulating substrate 101 comes inside, making connection of the terminal portion 103B of the conductive pattern 103 for external connection thereby to join the device to a glass substrate 118, and making connection of the other terminal portion 103B for external connection, thereby joining the device to a printed wiring board 117. In the drawing, the numeral 119 denotes a display glass, and 122 denotes a backlight.

However, in such semiconductor device 116, the semiconductor 107 in use generates heat. The generated heat is directly dissipated into ambient air, or dissipated through the connected conductive pattern 103 and sealing resin 114, or through the solder resist 106, insulating substrate 101 and other components connected thereto in turn into ambient air and other components located farther, such as a housing member 120.

However, the semiconductor 107, sealing resin 114, conductive pattern 103 and solder resist 106 are surrounded by the insulating substrate 101, and the thermal conductivity of the insulating substrate 101 is as small as 0.12 to 0.29 W/m•K approximately. Therefore, the heat cannot be conducted to the housing member 120 and ambient air efficiently, and the heat is trapped inside.

Under such circumstances, a display device to which the conventional semiconductor device 116 as described above is assembled achieves an aggravated effect in heat dissipation and tends to allow the temperature of a semiconductor 107 to rise eventually, and thus has problems including the one about the reduction of the operation speed of the semiconductor 107, and the one concerning the deterioration of the reliability of the semiconductor 107.

Some of conventional semiconductor devices proposed to solve such problems include the semiconductor devices as disclosed by e.g. Patent Citations 1 and 2, Japanese Unexamined Patent Application Publication Nos. JP-A-2006-108356 and JP-A-2006-135247.

Specifically, such semiconductor device, like the semiconductor device disclosed by Patent Citation 1, JP-A-2006-108356 as shown in FIG. 17A, for example, uses a flexible printed wiring board having an insulative film 303, a wire 304, a solder resist 305, a sealing resin 306, and a heat-dissipating plate 310 made of metal, and has a semiconductor element 301 which is incorporated therein by connecting a bump electrode 302 to the wire 304 laid out on one surface of the insulative film 303. The solder resist 305 is laid out around the semiconductor element 301. The sealing resin 306 is arranged so as to be in contact with all the side surfaces of the semiconductor element 301, thereby fixing the semiconductor element 301 to the insulative film 303.

The heat-dissipating plate 310 is laid out on a side opposite to the side where the semiconductor element 301 is arranged on the insulative film 303, corresponding to the semiconductor element 301 in position. The superficial area of the heat-dissipating plate 310 is smaller than that of the insulative film 303. In terms of the quality of material of the heat-dissipating plate 310, the heat dissipation property can be improved by using a material with a high thermal conductivity.

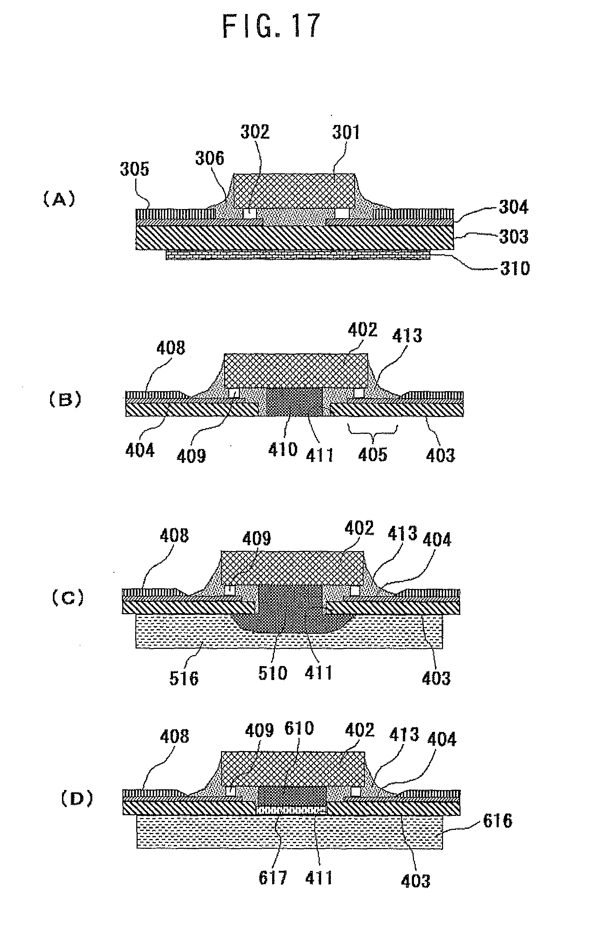

However, in this conventional semiconductor device as shown in FIG. 17A, a heat-conduction route along which heat generated by the semiconductor element 301 is conducted to the heat-dissipating plate 310 extends from the semiconductor element 301 through the bump electrode 302 made of gold, the wire 304 and the insulative film 303, to the heat-dissipating plate 310. Also, there is another heat-conduction route along which generated heat is conducted from the semiconductor element 301 to the sealing resin 306, and further transmitted through the insulative film 303 to the heat-dissipating plate 310. As described above, both the heat-conduction routes go through the insulative film 303.

Meanwhile, the bump electrode 302 of the semiconductor element 301, and the wire 304 are bonded together by pressurizing and heating them for a certain length of time. On this account, it is common to use, as the material of the insulative film 303, a heat-resistant polyimide which can withstand the heat applied.

However, the thermal conductivity of the polyimide is between 0.12 and 0.29 W/m•K approximately, which is relatively small. The heat-conduction route for conducting the generated heat from the semiconductor element 301 to the heat-dissipating plate 310 goes across the insulative film 303, and the heat is transmitted along the route. Hence, the heat has not been able to be conducted to the heat-dissipating plate 310 efficiently. On that account, there has been the problem that the amount of heat dissipation from the heat-dissipating plate 310 to air is also reduced, and the effect of heat dissipation cannot be increased.

Possible methods of providing the heat-dissipating plate 310 include a method of sticking the plate from the back, and a method of forming the plate by etching. However, the methods bring on the problem that they need apparatuses necessary for such processes and a number of steps for them, which increases the cost.

As another heat-conduction route, there is a route along which the heat from the semiconductor element 301 is transferred through the bump electrode 302 made of gold to the wire 304, and further transmitted to the solder resist 305, and then dissipated into the air. Such solder resist 305 is required to have flexibility. However, there has been a relation such that a solder resist superior in the flexibility has a poor thermal conductivity, resulting in the problem that the effect of heat dissipation through a solder resist with an excellent flexibility cannot be expected.

Besides, in assembling to a display device, the semiconductor device is put in the same condition as shown in FIG. 16. The semiconductor device is assembled by being curved so that the front face of the insulative film 303 comes inside, and connecting the wire 304 to the glass substrate and printed wiring board. As the thermal conductivity of the insulative film 303 is as small as 0.12 to 0.29 W/m•K approximately, and heat cannot be conducted to the ambient air, a housing member and others efficiently, the heat is trapped inside the device, which has been a problem.

Some of conventional semiconductor devices are arranged like the semiconductor device disclosed by Patent Citation 2, JP-A-2006-135247 as shown in FIG. 17B, for example, in which a liquid crystal driver chip 402 is connected with a flexible board 403 composed of a polyimide film having a through-hole 411 provided therein, the flexible board 403 has a patterned copper (Cu) wire 404 produced by electroless-plating with tin (Sn), and every part is protected by the solder resist 408 except an inner lead 405 and other input and output outer leads.

As to the connection between the flexible board 403 and liquid crystal driver chip 402, Au-Su eutectic-connection is made by thermocompressionally bonding between gold (Au) of a projecting electrode 409 and tin (Sn) plated over the Cu wire 404 of the flexible board 403. After that, a sealing resin 413 is charged into the gap between the flexible board 403 and liquid crystal driver chip 402.

A heat-dissipating component 410 is provided on the element' s surface of the liquid crystal driver chip 402. The heat-dissipating component 410 may be provided by electroless plating. Alternatively, a metal block may be thereto attached later, or a non-metallic substance like a thermally conductive rubber may be glued.

In this way, in the flexible board 403 provided with the through-hole 411, the heat-dissipating component 410 of the liquid crystal driver chip 402 is directly exposed to the outside through the through-hole 411 of the flexible board 403.

The heat-dissipating component 410 to be provided on the liquid crystal driver chip 402 is formed by: forming a copper (Cu) block in a rectangular prism shape by electrolytic plating; attaching a metal block later; or gluing thereto a non-metallic substance like a thermally conductive rubber. Hence, the heat generated by the liquid crystal driver chip 402 can be conducted to the heat-dissipating component 410 efficiently. In addition, because of the heat-dissipating component 410 directly exposed to the outside, a heat dissipation efficiency per unit area can be increased.

However, by such method, the heat-dissipating component 410 can be provided, in terms of the size, only in the inside region between the Au projecting electrodes 409 provided on the liquid crystal driver chip 402. Accordingly, the area of the heat-dissipating component 410 exposed to the outside is reduced, which presents the problem that the effect of heat dissipation cannot be much expected when the heat is dissipated into the ambient air directly. Also, there has been the problem of the increased cost because an apparatus to form a through-hole 411 in the flexible board 403 and a number of steps for such processing, as well as an apparatus to provide the heat-dissipating component 410, and a number of steps for such processing are required.

Some of conventional semiconductor devices are arranged like the semiconductor device disclosed by Patent Citation 2, JP-A-2006-135247 shown in FIG. 17C, for example, in which a first heat-dissipating component 510 exposed through a through-hole 411 of the flexible board 403 is put in close contact with a second heat-dissipating component 516 having a larger heat capacity, and the first heat-dissipating component 510 is grown by plating using the flexible board 403 as a mask until the resultant plating exceeds in height the flexible board 403. In this way, the plating grows toward all directions like a mushroom. With the first heat-dissipating component 510 with its exposed portion's superficial area so expanded, a thermally conductive rubber used as the second heat-dissipating component 516 having a larger heat capacity is brought into close contact. Thus, the effect of heat dissipation is achieved.

However, the following are indispensable in this method: to form the through-hole 411 in the flexible board 403; to form the first heat-dissipating component 510 by plating; and to bring a thermally conductive rubber used as the second heat-dissipating component 516 into close contact. Therefore, apparatuses and a number of processing steps indispensable for these processes are required, which presents the problem of rising costs.

Further, some of conventional semiconductor devices are arranged like the semiconductor device disclosed by Patent Citation 2, JP--A-2006-135247 shown in FIG. 17D, for example, in which the first heat-dissipating component 610 composed of a copper (Cu) block formed by plating is provided, and the liquid crystal driver chip 402 is connected with the flexible board 403 so that the exposed surface of the first heat-dissipating component 610 falls, in position, within the thickness of the flexible board 403.

In addition, a cavity is defined by the sidewall of the through-hole 411 of the flexible board 403, and the exposed surface of the first heat-dissipating component 610 making the bottom face thereof. Then, a thermally conductive adhesive agent 617 is charged into the cavity, followed by gluing the second heat-dissipating component 616 thereto further. Thus, a heat-conduction route from the liquid crystal driver chip 402 to the second heat-dissipating component 616 is provided, whereby the effect of heat dissipation is achieved.

However, this method includes forming the through-hole 411 in the flexible board 403, forming the first heat-dissipating component 610 by plating, charging the thermally conductive adhesive agent 617, and gluing the second heat-dissipating component 616 further. Therefore, apparatuses and a number of processing steps indispensable for these processes are required, which presents the problem of rising costs.

On this account, some of conventional semiconductor devices are arranged like the semiconductor device 201a disclosed by Patent Citation 3, Japanese Unexamined Patent Application Publication No. JP-A-2004-235353 as shown in FIGs. 18A and 18B, for example, in which a conductor lead 204 is formed on a film substrate 202, a semiconductor element 205 is mounted thereon, and has a metal electrode 208 connected to the conductor lead 204 through a bump 206.

The gap between the semiconductor element 205 and film substrate 202, and the periphery of the metal electrode 208 of the semiconductor element 205 are respectively charged and covered with a sealing resin 207 for surface protection and for ensuring the strength of the semiconductor device 201a per se. Outside the region where the sealing resin 207 is formed, a solder resist 203 to make a covering portion is formed, which partially covers the conductor lead 204. In an area where no solder resist 203 is formed, the conductor lead 204 is exposed.

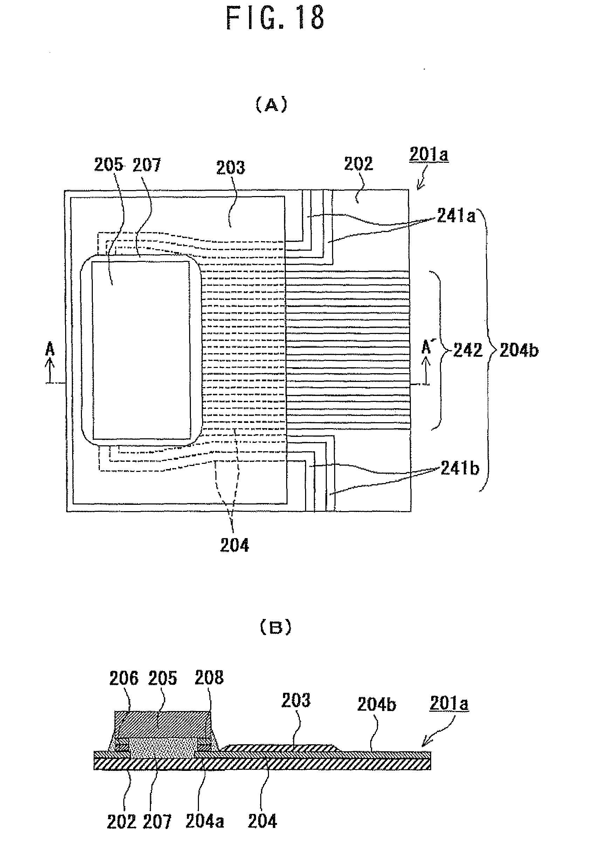

A portion of the conductor lead 204, which includes a portion electrically connected with the metal electrode 208 of the semiconductor element 205, and is covered with the sealing resin 207 and in close contact with the film substrate 202, is referred to as an inner lead 204a. A portion of the conductor lead 204 exposed from the solder resist 203 is referred to as an outer lead 204b, which is used as a mounting area to the display device. As shown in FIG. 18A, the outer leads 204b are classified into input wires 241a and 241b arranged in bent forms, and a display signal wire 242 in a straight-line form.

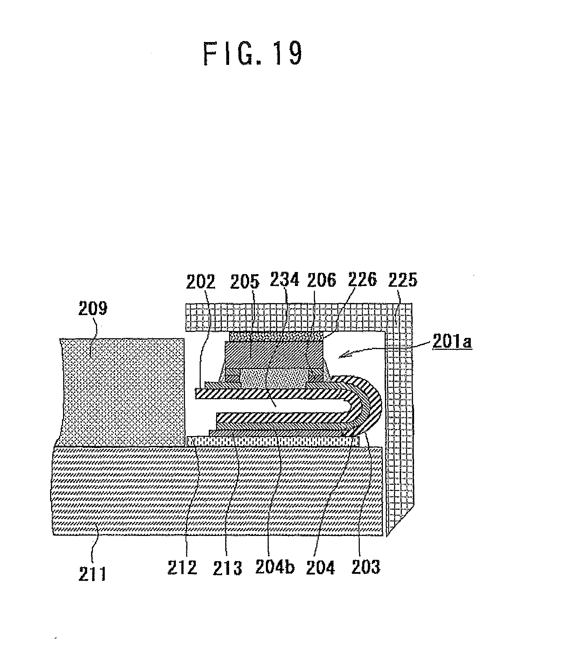

FIG. 19 shows an example of using the semiconductor device shown in FIGs. 18A and 18B.
The semiconductor device 201a is arranged in the form as follows. That is, the film substrate 202 is folded so that the rear face opposite from the front face, on which the semiconductor element 205 is placed, comes inside. Also, in this form, the opposite ends of the film substrate 202 are set close to each other, and the front face, on which the outer lead 204b is formed, points toward the backside. Besides, the glass substrate 211 as a display panel, and the display glass 209 as a transparent substrate are stacked up in order, and an anisotropically conductive film 213 and other constituents are formed on a transparent electrode 212 formed on the side of the glass substrate 211 facing the display glass 209. Then, the semiconductor device 201a is mounted. The semiconductor device 201a takes a shape in which the film substrate 202 is folded with its rear face inward. The outer lead 204b of the semiconductor device 201a, and the transparent electrode 212 of the glass substrate 211 are bonded and electrically connected through the anisotropically conductive film 213.

Now, the references herein cited are listed below.
Patent Citation 1: Japanese Unexamined Patent Application Publication No. JP-A-2006-108356,
Patent Citation 2: No. JP-A-2006-135247,
Patent Citation 3: No. JP-A-2004-235353, and
Patent Citation 4: No. JP-A-2003-309150.

### DISCLOSURE OF INVENTION

### TECHNNICAL PROBLEM

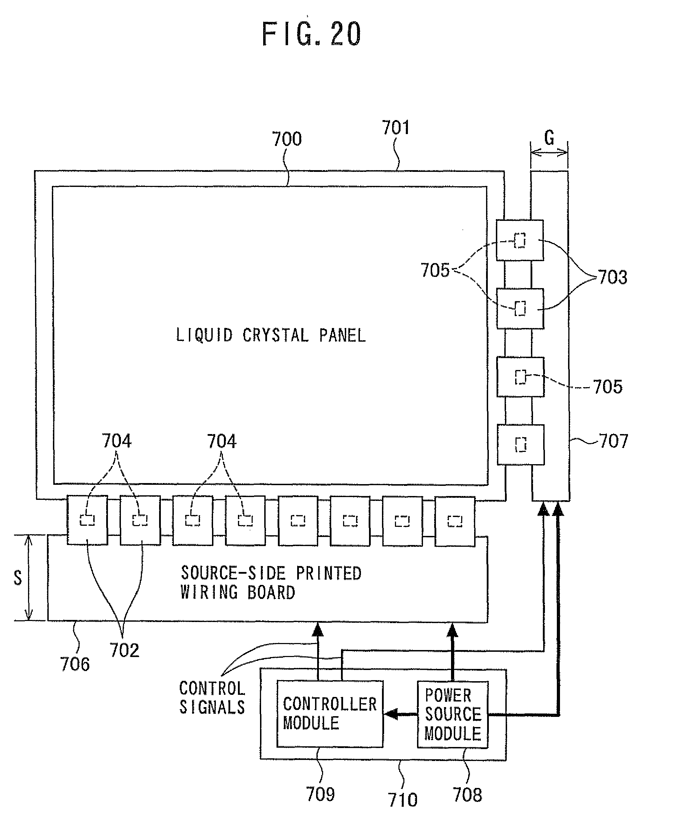

Meanwhile, a liquid crystal display device has, as shown in FIG. 20, a glass substrate 701 with TUFTS formed thereon. To the glass substrate 701 are connected source-side semiconductor devices 702 and gate-side semiconductor devices 703 for driving TFTs. Behind them, a source-side printed wiring board 706 and a gate-side printed wiring board 707 are connected to supply various kinds of control signals and a source voltage, which are necessary for driving semiconductors 704 and 705 incorporated in the source-side semiconductor devices 702 and gate-side semiconductor devices 703. Further behind them, a printed wiring board 710 equipped with a power source module 708 and a controller module 709 is connected.

Liquid crystal display devices are characterized by being able to be slimmed in structure. Therefore, it is demanded to slim in profile such display devices as well as to make them more compact. In compliance with such demands, the source-side printed wiring board 706 and gate-side printed wiring board 707 are formed to have a rectangle like an elongated thin plate. In addition, it is required to minimize the width size S of the source-side printed wiring board 706 and the width size G of the gate-side printed wiring board 707, which are shown in FIG. 20. However, lots of wires must be provided on the source-side printed wiring board 706, and digital signals with frequencies as high as tens of megahertz run on the wires thus formed, causing noises. Further, as the source-side printed wiring board 706 is used a multilayered printed wiring board with a grounded wire provided thereon for making possible to provide lots of wires and for helping the absorption of noises. The grounded wire needs some width and area because the wire is thinned and reduced in its area, whereby the effect thereof is made smaller. Owing to such circumstance in addition to the factor of lots of wires being needed, there has been the problem that the width size S of the source-side printed wiring board 706 cannot be made smaller than the width size G of the gate-side printed wiring board 707.

As it is required to further downsize liquid crystal display devices, the means of curving and folding the semiconductor devices 702 and 703 thereby to reduce the area of the periphery of the display panel 700 (hereinafter referred to as "frame edge") has been often used in general. Now, FIG. 20 is a diagram showing the display panel 700 as viewed from its front side. The semiconductors 704 and 705 incorporated in the semiconductor devices 702 and 703 are mounted on the backside of the display panel 700. Therefore, the better heat dissipation efficiency can be achieved in the case of curving and folding the semiconductor devices 702 and 703 toward the direction of the front side of the display panel 700, thereby to arrange the semiconductors 704 and 705 outwardly from the curved semiconductor devices 702 and 703.

However, in the case of folding the semiconductor devices in such direction, the source-side printed wiring board 706 and gate-side printed wiring board 707 must be assembled so that they are located outside the display glass 700 in order to avoid them interfering with a display region (i.e. the region of the display glass 700). In the case of making an arrangement like this, a wider frame edge is needed around the display panel 700 because of the impossibility of making smaller the width size S of the source-side printed wiring board 706, which poses the problem that it becomes impossible to meet the need for downsizing a liquid crystal display device. In addition, as to the flexible printed wiring boards used for the semiconductor devices 702 and 703, larger ones are needed, resulting in the rise of the cost.

Therefore, the means of curving and folding the semiconductor devices toward the backside of the display panel 700, and placing the source-side printed wiring board 706 and gate-side printed wiring board 707 on the backside of the liquid crystal panel as shown in FIG. 20 thereby making smaller the frame edge has been taken in general. This means worsens the heat dissipation efficiency because the semiconductors 704 and 705 are located inward with respect to the curved semiconductor devices 702 and 703, however it is carried out in general because of putting priority on the downsizing of a liquid crystal display device.

However, in recent years, liquid crystal display devices have not only advanced in enhancement of resolution and definition, but also been subjected to improvements for increasing operating speeds of semiconductors to achieve a better resolution of a moving picture.
Consequently, the amount of heat generation by semiconductors has been increasing, and it has been required to dissipate such heat efficiently. Now, it is noted that as the width size G of the gate-side printed wiring board 707 can be made relatively small, the semiconductor device 703 can be not folded, but assembled in cases that there is no problem about the required frame edge size.

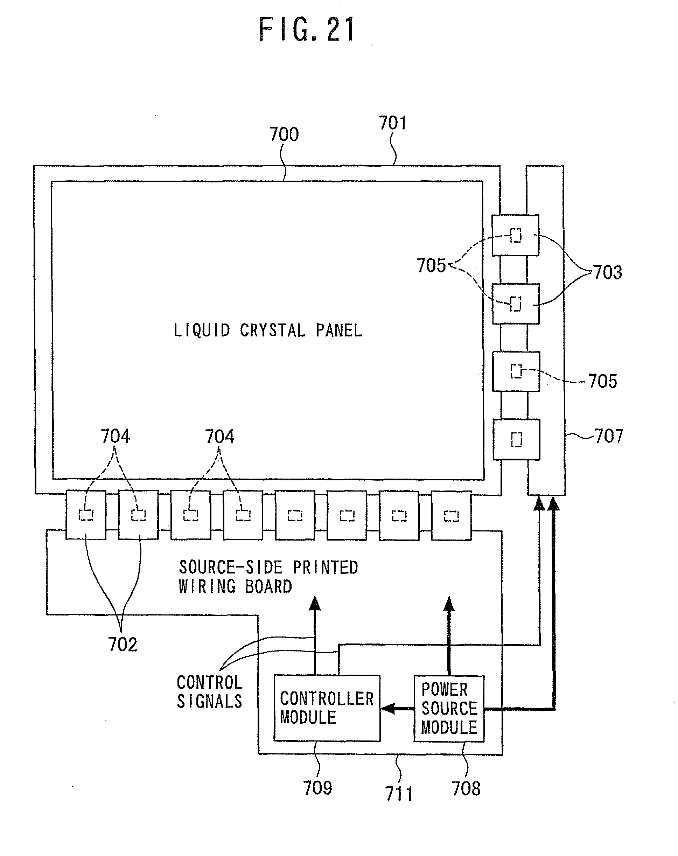

Further, in the case of placing the source-side printed wiring board 706 on the backside of the liquid crystal panel as described above, it becomes possible to enlarge the width size S of the source-side printed wiring board 706 taking into account countermeasures against noises. Also, like the printed wiring board 711 shown in FIG. 21, the means of uniting the source-side printed wiring board 706 and the printed wiring board 710 provided with the power source module 708 and controller module 709 to reduce the number of parts or components, thereby lowering the manufacturing and assembly costs of parts is used in general.

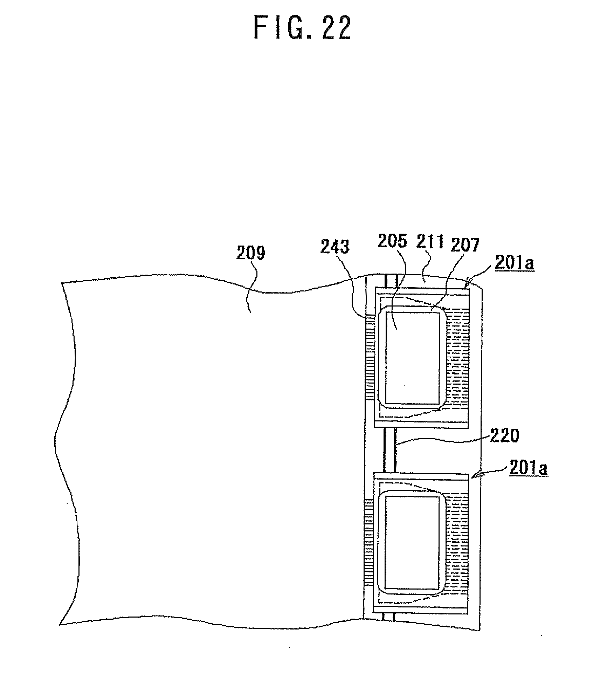

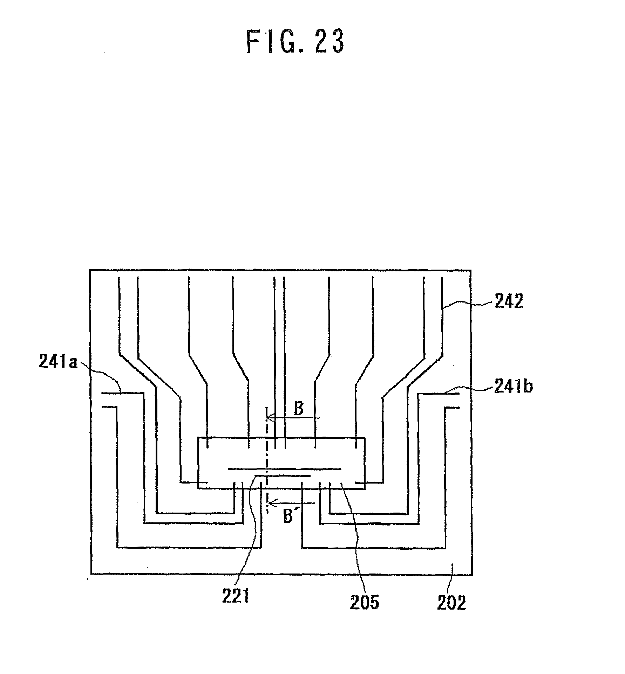

Incidentally, according to the above method shown with reference to FIG. 19, routes to transfer a source voltage and a signal are established by connecting a link wire 220 as shown in FIG. 22 with input and output wires 241a and 241b as shown in FIG. 23 by use of the anisotropically conductive film 213 as shown in FIG. 19. The same connection is made with a subsequent semiconductor device as shown in FIG 22. Then, such connection is iterated, whereby many semiconductor devices 201a and link wires 220 are connected in series. Incidentally, as to the link wires 220, it is common that it is formed by building up a conducting-wire layer on the front face of the glass substrate 211 by the film-formation process or the like, and patterning it.

The link wire 220 in this way cannot be increased, in thickness, like the conductive pattern 103 as shown in FIG. 16, which is formed on a flexible printed wiring board by using metal to build up a conductor by means of electrolytic plating and etching it, and like a conductive pattern (not shown) formed on the printed wiring board 117 as shown in FIG. 16 by e.g. sticking a sheet of copper foil thereby to prepare a conductor and etching it. On this account, it is difficult to lower the electrical resistance of the link wire 220, which has been a problem.

Therefore, as to large-size liquid crystal display devices, the semiconductor devices 201a and link wires 220, which are connected in series, are increased in number, and consequently the electrical resistance becomes larger, and so does the voltage drop. As a result, it becomes impossible to secure the voltage necessary for the semiconductor 205 to work, which presents a problem. Particularly, in regard to the source side, it becomes a matter because a large volume of current must be passed there, and therefore it is required to lower the electrical resistance thereby to make smaller the voltage drop.

On that account, as to the source side of a large-size display device, a method that the printed wiring board 117 as shown in FIG. 16 is commonly used. Form this point, the technique according to Patent Citation 3, JP-A-2004-235353, has the problem that it cannot be used for the source side of a large-size liquid crystal display device.

Therefore, it is an object of the invention to provide: a semiconductor device with a good heat dissipation efficiency which never causes the rise of the cost owing to the increase of processing apparatuses and/or steps in number, and is not deteriorated in reliability; a display device using the semiconductor device; and a method of manufacturing the semiconductor device.

Further, it is another object of the invention to provide: a semiconductor device which has a semiconductor mounted on a flexible printed wiring board by connecting with a semiconductor-connecting terminal portion between first and second external-connection terminal portions of a conductive pattern on the flexible printed wiring board, and which achieves a good heat dissipation efficiency with respect to the semiconductor when mounted by folding an insulating substrate so that its front face comes inside, and connecting the first and second external-connection terminal portions with other components respectively; a display device using such semiconductor device; and a method of manufacturing the semiconductor device.

### TECHNICAL SOLUTION

To achieve the objects, according to the first embodiment of the invention, a semiconductor device includes: a flexible printed wiring board, having a flexible insulating substrate, and a conductive pattern formed on a front face of the insulating substrate and provided with a semiconductor-connecting terminal portion, and first and second external-connection terminal portions located on opposite sides of the semiconductor-connecting terminal portion; a semiconductor connected with the semiconductor-connecting terminal portion of the conductive pattern and then mounted on the printed wiring board; a slit formed in the insulating substrate so as to surround the semiconductor while partially leaving surrounding areas thereof; and a semiconductor-holding part provided by forming the slit, wherein the slit is formed so that the mounted semiconductor juts outwardly from a rear face of the insulating substrate when folding the insulating substrate so that the front face thereof comes inside except the semiconductor-holding part, and connecting the first and second external-connection terminal portions with other components respectively.

In the semiconductor device, the slit is formed in e.g. a horseshoe shape or a shape like the Japanese katakana letter expressing the syllable "KO" so as to surround three sides of the semiconductor having a quadrangular shape in outward appearance.

When using the semiconductor device, it is curved in a bending zone between a straight line going through two opposite ends of the slit and across the insulating substrate and a straight line parallel therewith to fold the insulating substrate so that the front face comes inside except the semiconductor-holding part, and then the conductive pattern is connected with other components. The semiconductor-holding part may be left extending straight without being curved. Alternatively, the semiconductor-holding part may be turned back so that the rear face comes inside, and then the semiconductor may be glued to a housing member through a high-heat-conductive material, or otherwise pressed against the housing member by a repulsion force of the insulating substrate, for example.

In order to make possible to curve the insulating substrate in a bending zone between a straight line going through two opposite ends of the slit and across the insulating substrate and a straight line parallel therewith so that the rear face comes inside, thereby to turn back the semiconductor-holding part, the straight line going through the opposite ends of the slit and across the insulating substrate is spaced away from the semiconductor by a predetermined distance. Besides, the semiconductor-holding part is turned back on the bending zone so that the rear face comes inside, and opposing portions of the insulating substrate thus arranged may be stuck together with an adhesive or the like.

A display device according to the second embodiment of the invention has the semiconductor device according to the first embodiment mounted thereon, wherein the semiconductor device is mounted by curving the insulating substrate in a bending zone between a straight line going through two opposite ends of the slit and across the insulating substrate and a straight line parallel therewith, to fold the insulating substrate so that its front face comes inside except the semiconductor-holding part, and connecting the first and second external-connection terminal portions of the conductive pattern with other components. In the display device, the semiconductor-holding part may be left extending straight without being curved. Alternatively, the semiconductor-holding part may be turned back so that the rear face comes inside, and then the semiconductor may be glued to a housing member through a high-heat-conductive material or otherwise pressed against the housing member by a repulsion force of the insulating substrate, for example. Further, the semiconductor-holding part can be, for example, turned back on the bending zone so that the rear face comes inside. After having turned back the semiconductor-holding part, opposing portions of the insulating substrate thus arranged may be stuck together with an adhesive or the like.

A method of manufacturing a semiconductor device according to the third embodiment of the invention includes the steps of: mounting a semiconductor between first and second external-connection terminal portions provided in a conductive pattern formed on a front face of a flexible insulating substrate of a flexible printed wiring board by connecting with a semiconductor-connecting terminal portion of the conductive pattern on the flexible printed wiring board; then, forming a slit in the insulating substrate so as to surround the semiconductor while partially leaving surrounding areas thereof thereby to provide a semiconductor-holding part, in which the slit is formed so that the mounted semiconductor juts outwardly from a rear face of the insulating substrate when folding the insulating substrate except the semiconductor-holding part so that its front face comes inside, and connecting the first and second external-connection terminal portions with other components respectively; and after or in parallel with the slit formation, stamping out the flexible printed wiring board in unit of the conductive pattern.

Further, another method of manufacturing a semiconductor device includes the steps of: providing a first cut in a flexible insulating substrate of a flexible printed wiring board with a conductive pattern formed on a front face of the insulating substrate and provided with first and second external-connection terminal portions in order to prevent a tension applied to the flexible printed wiring board from affecting an inter-terminal pitch of a semiconductor-connecting terminal portion of the conductive pattern when conveying the flexible printed wiring board; then, mounting a semiconductor between the first and second external-connection terminal portions on the flexible printed wiring board by connecting with the semiconductor-connecting terminal portion; subsequently, providing a second cut including or connecting with the first cut to form a slit in the insulating substrate so as to surround the semiconductor while partially leaving surrounding areas thereof and to provide a semiconductor-holding part, in which the slit is formed so that the mounted semiconductor juts outwardly from a rear face of the insulating substrate when folding the insulating substrate except the semiconductor-holding part so that its front face comes inside, and connecting the first and second external-connection terminal portions with other components respectively; and after or in parallel with the slit formation, stamping out the flexible printed wiring board in unit of the conductive pattern.

In the method of manufacturing a semiconductor device according to the third embodiment, the semiconductor-holding part can be turned back on a bending zone between a straight line going through two opposite ends of the slit and across the insulating substrate and a straight line parallel therewith so that the rear face comes inside.

A method of manufacturing a display device according to the fourth embodiment of the invention includes the steps of: forming a semiconductor device on the manufacturing method according to the third embodiment; and then, folding the insulating substrate on a bending zone between a straight line going through two opposite ends of the slit and across the insulating substrate, and a straight line parallel therewith so that its front face comes inside except the semiconductor-holding part, and connecting the first and second external-connection terminal portions of the conductive pattern with other components. In the manufacturing method, the semiconductor-holding part can be left extending straight without being curved. Alternatively, the semiconductor-holding part may be turned back so that the rear face comes inside, and then the semiconductor may be glued to a housing member through a high-heat-conductive material, for example. Also, the semiconductor-holding part can be turned back by being curved in the bending zone so that the rear face comes inside, and opposing portions of the insulating substrate thus arranged can be stuck together with an adhesive or the like.

### ADVANTAGEOUS EFFECTS

According to the semiconductor device associated with the first embodiment of the invention, when using the semiconductor device, the insulating substrate is folded so that the front face comes inside except the semiconductor-holding part, and the conductive pattern is connected with other components, in which the semiconductor-holding part is left extending straight without being curved, or otherwise turned back so that the rear face comes inside, followed by gluing the semiconductor to a housing member through e.g. a high-heat-conductive material. Therefore, when the semiconductor device is mounted in a condition in which the insulating substrate is folded with its front face inward except the semiconductor-holding part, the mounted semiconductor is arranged to jut outwardly from the rear face of the curved insulating substrate of the semiconductor device and as such, surrounding areas of the semiconductor can be made open, and the semiconductor can be brought into contact with another member. Hence, the heat dissipation efficiency can be increased without raising the cost owing to the increase of processing apparatuses and/or steps in number and without decreasing the reliability.

With regard to this semiconductor device, in the case of spacing the straight line going through the opposite ends of the slit and across the insulating substrate from the semiconductor by a predetermined distance and turning back the semiconductor-holding part by curving it in the bending zone so that the rear face comes inside, the shape of the semiconductor device in outward appearance can be made smaller. Further, sticking between the opposing portions of the insulating substrate at time of turning back the semiconductor-holding part can made the semiconductor device easier to handle, and easier to assemble to a display device or other things.

According to the display device associated with the second embodiment of the invention, the semiconductor device is mounted by being curved along a straight line going through two opposite ends of the slit and across the insulating substrate or a straight line parallel with it thereby to fold the insulating substrate so that the front face comes inside except the semiconductor-holding part, and connecting the conductive pattern with other components; the semiconductor-holding part is left extending straight without being curved, or otherwise turned back so that the rear face comes inside, followed by gluing the semiconductor to a housing member through e.g. a high-heat-conductive material. Therefore, when the semiconductor device is mounted in a condition in which the insulating substrate is folded with its front face inward except the semiconductor-holding part, the mounted semiconductor is arranged to jut outwardly from the rear face of the curved insulating substrate of the semiconductor device and as such, surrounding areas of the semiconductor can be made open, and the semiconductor can be brought into contact with another member. Hence, the heat dissipation efficiency can be increased without raising the cost owing to the increase of processing apparatuses and/or steps in number and without decreasing the reliability.

In regard to this display device, in a case that a semiconductor is glued to a housing member through a high-heat-conductive material, the heat can be dissipated more efficiently, lowering the temperature of the semiconductor, stabilizing the semiconductor in operation, and thus making better the quality of display of the display device because of using the high-heat-conductive material. Besides, in the case of turning back the semiconductor-holding part by curving it in the bending zone so that the rear face comes inside, a display device small in the shape in outward appearance, namely the so-called frame edge size, can be obtained. Further, in the case of sticking together between opposing portions of the insulating substrate at time of turning back the semiconductor-holding part, a semiconductor device easier to handle, and a display device arranged so that a semiconductor device can be assembled easier can be achieved.

According to the method of manufacturing a semiconductor device associated with the third embodiment of the invention, when using the manufactured semiconductor device, the insulating substrate is folded so that the front face comes inside except the semiconductor-holding part, and the conductive pattern is connected with other components, in which the semiconductor-holding part is left extending straight without being curved, or otherwise turned back so that the rear face comes inside, followed by gluing the semiconductor to a housing member through e.g. a high-heat-conductive material. Therefore, when the semiconductor device is mounted in a condition in which the insulating substrate is folded with its front face inward except the semiconductor-holding part, the mounted semiconductor is arranged to jut outwardly from the rear face of the curved insulating substrate of the semiconductor device and as such, surrounding areas of the semiconductor can be made open, and the semiconductor can be brought into contact with another member. Hence, a semiconductor device which can increase the heat dissipation efficiency without raising the cost owing to the increase of processing apparatuses and/or steps in number and without decreasing the reliability can be achieved.

On another note, as to the method of manufacturing a semiconductor device according to the third embodiment, in the case of arranging the method so that the first cut is provided first, and after mounting a semiconductor, the second cut is provided, thereby to complete the slit, at time of conveying the flexible printed wiring board with a conductive pattern formed on the front face of its flexible insulating substrate, a tension applied to the flexible printed wiring board can be prevented from affecting the inter-terminal pitch of the semiconductor-connecting terminal portion of the conductive pattern. As a result, the alignment in position between the semiconductor-connecting terminal portion and a gold bump provided on the semiconductor can be performed readily and precisely. In this manufacturing method, in the case of turning back the semiconductor-holding part by curving it in the bending zone so that the rear face comes inside, a semiconductor device having a small shape in outward appearance can be gained.

According to the method of manufacturing a display device associated with the fourth embodiment of the invention, when using the manufactured display device, the semiconductor device is mounted by being curved along a straight line going through two opposite ends of the slit and across the insulating substrate or a straight line parallel with it thereby to fold the insulating substrate so that the front face comes inside except the semiconductor-holding part, and connecting the conductive pattern with other components; the semiconductor-holding part is left extending straight without being curved, or otherwise turned back so that the rear face comes inside, followed by gluing the semiconductor to a housing member through e.g. a high-heat-conductive material. Therefore, when the semiconductor device is mounted in a condition in which the insulating substrate is folded with its front face inward except the semiconductor-holding part, the mounted semiconductor is arranged to jut outwardly from the rear face of the curved insulating substrate of the semiconductor device and as such, surrounding areas of the semiconductor can be made open, and the semiconductor can be brought into contact with another member. Hence, a display device which can increase the heat dissipation efficiency without raising the cost owing to the increase of processing apparatuses and/or steps in number and without decreasing the reliability can be achieved.

In regard to this manufacturing method, in a case that a semiconductor is glued to a housing member through a high-heat-conductive material, it is made possible by using such high-heat-conductive material to achieve a display device which can dissipate the heat to lower the temperature of the semiconductor more efficiently, and which is further stabilized in semiconductor operation. In addition, in the case of turning back the semiconductor-holding part by curving it in the bending zone so that the rear face comes inside, a display device small in the shape in outward appearance, namely the so-called frame edge size, can be obtained.

### BRIEF DESCRIPTION OF DRAWING

[FIGs. 1A-1F] FIGs. 1A-1F are illustrations of a process of steps for manufacturing a flexible printed wiring board used to manufacture a semiconductor device of the invention.
[FIG. 2] FIG. 2 is a plane view of a flexible printed wiring board manufactured according to the manufacturing process shown by FIGS. 1A-1F.
[FIGs. 3A-3D] FIGs. 3A-3D are illustrations of a process of steps for manufacturing the semiconductor device of the invention.
[FIG. 4] FIG. 4 is a plane view of a semiconductor device manufactured according to the manufacturing process shown in FIG. 3.
[FIG. 5] FIG. 5 is an illustration of a situation where the semiconductor device shown in FIG. 4 is used.
[FIG. 6] FIG. 6 is an illustration of another situation where the semiconductor device shown in FIG. 4 is used.
[FIG. 7] FIG. 7 is an illustration of another situation where the semiconductor device shown in FIG. 4 is used.
[FIG. 8] FIG. 8 is an illustration of another situation where the semiconductor device shown in FIG. 4 is used.
[FIG. 9] FIG. 9 is a longitudinal sectional view of another semiconductor device of the invention.
[FIG. 10] FIG. 10 is an illustration of a situation where the semiconductor device shown in FIG. 9 is used.
[FIG. 11] FIG. 11 is a plane view of a flexible printed wiring board manufactured according to another manufacturing process of the invention.
[FIG. 12] FIG. 12 is a plane view of a semiconductor device incorporating the flexible printed wiring board shown in FIG. 11.
[FIG. 13] FIG. 13 is a plane view of another flexible printed wiring board manufactured according to another manufacturing process of the invention.
[FIG. 14] FIG. 14 is a plane view of a semiconductor device incorporating the flexible printed wiring board shown in FIG. 13. [FIGs. 15A-15B] FIG. 15A is a sectional view of a conventional semiconductor device, and FIG. 15B is a plane view thereof.
[FIG. 16] FIG. 16 is an illustration of a situation where the conventional semiconductor device shown in FIG. 15 is used.
[FIGs. 17A-17D] FIGs. 17A-17D are each a longitudinal sectional view of another conventional semiconductor device.
[FIGs. 18A-18B] FIG. 18A is a plane view of another conventional semiconductor device, and FIG. 18B is a longitudinal sectional view thereof.
[FIG. 19] FIG. 19 is an illustration of a situation where the semiconductor device shown by FIGs. 18A and 18B is used.
[FIG. 20] FIG. 20 is a plane view of a liquid crystal display device.
[FIG. 21] FIG. 21 is a plane view of another liquid crystal display device.
[FIG. 22] FIG. 22 is a plane view of a situation where the semiconductor device shown by FIGs. 18A and 18B is used.
[FIG. 23] FIG. 23 is a plane view schematically showing wires of the semiconductor device shown by FIGs. 18A and 18B.

### EXPLANATION OF REFERENCE

- 1:: Insulating Substrate
- 2:: Conductor
- 3:: Conductive Pattern
- 3A:: Semiconductor-connecting Terminal Part
- 3B:: External-connection Terminal Part
- 3B1:: First External-connection Terminal Part
- 3B2:: Second External-connection Terminal Part
- 3C:: Reinforcing Part
- 4:: Photoresist Film
- 5:: Slit
- 5A:: First Cut
- 5B:: Second Cut
- 6:: Solder Resist
- 7:: Semiconductor
- 7A:: Semiconductor-mounting Region
- 8:: Gold Bump
- 9:: Bonding Tool
- 10:: Heating Stage
- 11:: Sprocket Hole
- 12:: Flexible Printed Wiring Board
- 13:: Coating Nozzle
- 14:: Sealing Resin
- 15:: Etching Resist
- 16:: Semiconductor Device
- 16A:: Semiconductor Device
- 17:: Printed Wiring Board (Other Component)
- 18:: Glass Board (Other Component)
- 19:: Display Glass
- 20:: First Housing Member
- 21:: Second Housing Member
- 22:: Backlight
- 23:: High-heat-conductive Material
- 24:: Adhesive
- 30:: Semiconductor-holding Part
- 40:: Display Device
- a:: Predetermined Distance
- b:: Bending Zone
- L:: Straight line going through two opposite ends of the slit and across the insulating substrate
- M:: Straight line parallel to Line L

### BEST MODE FOR CARRYING OUT THE INVENTION

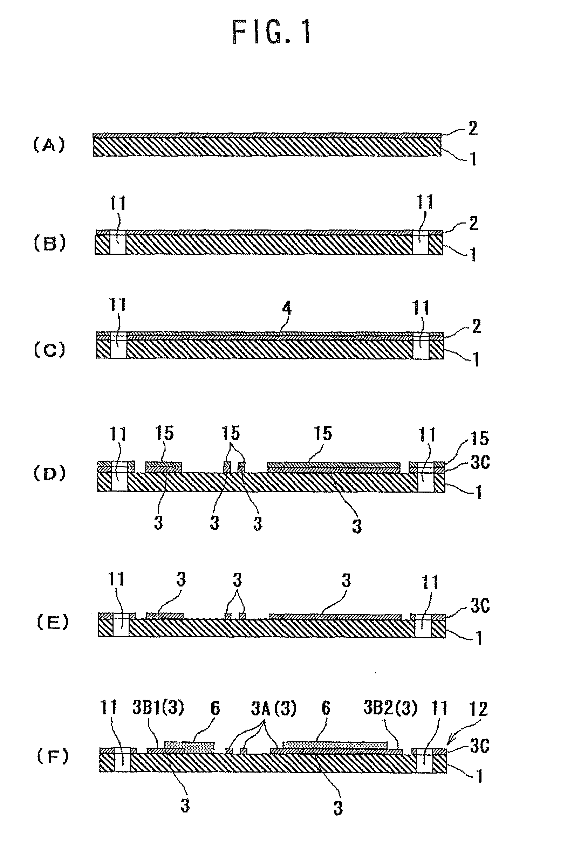

The preferred embodiments of the invention will be described below with reference to the drawings.
Referring to FIGs. 1A to 1F, a process for manufacturing a flexible printed wiring board used for manufacturing the semiconductor device of the invention is shown.

In the process for manufacturing a flexible printed wiring board used in the invention, a substrate provided with a conductor 2 for conductive pattern formation is prepared; the conductor is applied all over the front face of a flexible insulating substrate 1 constructed of an elongated plastic film, as shown in FIG. 1A. Used as the insulating substrate 1 is polyimide with a thickness of 12.5 to 50 µm in general. For example, a material of the trade name "UPILEX" manufactured by Ube Industries, Ltd., and a material of the trade name "KAPTON" manufactured by Du Pont-Toray Co., Ltd. may be used. Then, a conductor 2 made of metal is formed on one side of such insulating substrate 1 by sputtering or electrolytic plating. In this example, a material of the trade name "S' PERFLEX" manufactured by Sumitomo Metal Mining Co., Ltd., which was formed by copper-plating after sputtering, was used as the conductor 2.

Otherwise, e.g. a material of the trade name "ESPANEX" manufactured by Nippon Steel Chemical Co., Ltd., which was prepared by applying, drying and curing a polyimide precursor resin liquid solution, can be used as the copper foil constituting the conductor 2. Incidentally, a material, such as polyethylene or polyester may be used for the insulating substrate 1, instead of polyimide described above.

By using a metal mold to stamp out the substrate formed in the way as described above, sprocket holes 11 are formed in opposite edge portions of the substrate to be bilaterally symmetrical along the opposite edges thereof at regular intervals in a direction of length as shown in FIG. 1B.

Subsequently, the substrate is conveyed with the sprocket holes 11, and in parallel, a coat of photoresist is put on the front face of the conductor 2 uniformly using e.g. a roll coater, dried and cured. Thus, the photoresist film 4 is formed as shown in FIG. 1C.

Next, as shown in FIG. 1D, while being positioned by use of the sprocket holes 11, the photoresist film is exposed and developed, whereby the etching resist 15 is formed. Then, the substrate is further subjected to etching, whereby identical conductive patterns 3 of units formed in turn repeatedly in the direction of length, and reinforcing parts 3C of the sprocket holes 11 formed successively in the direction of length are provided. In addition, in this example, copper is used as the material for the conductor 2, and therefore an etchant of ferric chloride solution is used for the etchant to perform the etching.

Then, the etching resist 15, which has become unnecessary after etching, is removed by an alkaline processing liquid as shown in FIG. 1E.

Subsequently, while the graphic representation is skipped, tin or gold plating shall be performed on the front face of the conductive pattern 3 for the purposes of connection with a semiconductor to be incorporated therein and protection of the conductive pattern 3 on the insulating substrate 1 against corrosion and rust, as later described. In this example, tin plating is carried out.

Next, as shown in FIG. 1F, while leaving a semiconductor-connecting terminal portion 3A for later connecting a semiconductor, and an external-connection terminal portion 3B for connecting a glass substrate of a display device or a printed wiring board, the solder resist 6 superior in flexibility is provided on other regions by the following procedure. That is, a coat of the solder resist is put on the regions by e.g. screen printing, and then heated and cured. The external-connection terminal portion 3B consists of a plurality of first external-connection terminal portions 3B1 and a plurality of second external-connection terminal portions 3B2; the first and second external-connection terminal portions are provided on opposite sides respectively so that the semiconductor-connecting terminal portion 3A is located therebetween. In this example, a solder resist of the trade name "SN-9000" manufactured by Hitachi Chemical Co., Ltd. is used as the solder resist 6 superior in flexibility. The step of coating the solder resist 6 may be performed before or after the step of plating.

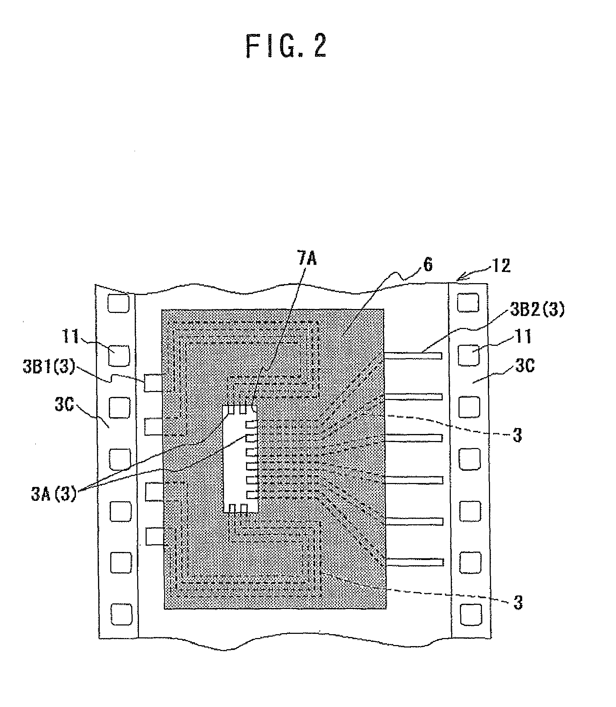

After these steps, the flexible printed wiring board 12 is formed. FIG. 2 presents a plane view of the flexible printed wiring board 12 thus formed. Now, it is noted that the solder resist 6 is provided leaving a semiconductor-mounting region 7A of a rectangular shape for mounting a semiconductor having a quadrangular shape in outward appearance, and the semiconductor-connecting terminal portions 3A show up from within the semiconductor-mounting region 7A.
Further, in order to ensure a region for forming a slit 5 later, the conductive pattern 3 is formed so that it surrounds three sides of the semiconductor-mounting region 7A, and goes around the slit-forming region of a horseshoe shape. A plurality of first external-connection terminal portions 3B1 and a plurality of second external-connection terminal portions 3B2 are provided on opposite sides of the semiconductor-mounting region 7A respectively with the slit-forming region located therebetween.

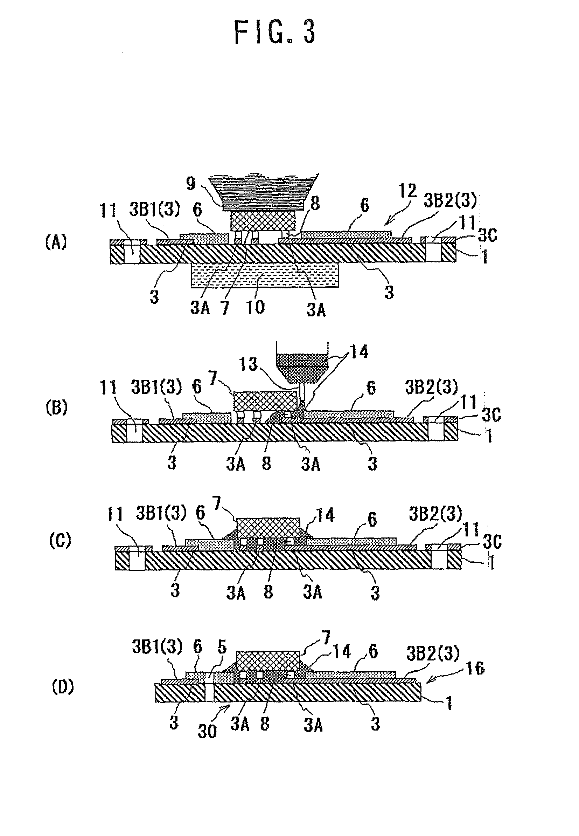

Now, the manufacturing process for mounting a semiconductor 7 on the flexible printed wiring board 12 to form a semiconductor device will be described with reference to FIGs. 3A to 3D.

First, the flexible printed wiring board 12 is conveyed with the sprocket holes 11, and positioned in turn, and in sequence, a semiconductor 7 having a quadrangular shape in outward appearance is set on a heating stage 10 set to 100 to 150 °C, as shown in FIG. 3A. Then, gold bumps 8 formed on the semiconductor 7 are opposed to and brought into contact with the semiconductor-connecting terminal portions 3A of the conductive pattern 3, followed by applying heat and pressure using a bonding tool 9 heated to 400 to 500 °C. Thus, between the first and second external-connection terminal portions 3B1 and 3B2, e.g. an Au-Sn eutectic bond of the gold bumps 8 and semiconductor-connecting terminal portion 3A plated with tin is formed, and the semiconductor 7 is mounted on the front face of the insulating substrate 1 of the flexible printed wiring board 12 by the flip chip mounting.

After that, the flexible printed wiring board 12 is conveyed with the sprocket holes 11, and positioned in turn. Then, sealing resin 14 discharged from a coating nozzle 13 is put along the periphery of the semiconductor 7 as shown in FIG. 3B. The resin penetrates into between the semiconductor 7 and insulating substrate 1 owing to a capillary phenomenon, thereby filling in therebetween. FIG. 3C shows a condition after the resin has been heated and cured.

Next, as shown in FIG. 3D, the flexible printed wiring board is stamped out with a pair of metal molds composed of a punch and a die to form a slit 5 in a horseshoe shape so that it surrounds three sides of the semiconductor having a quadrangular shape in outward appearance, whereby a semiconductor-holding part 30 is provided. The slit 5 may be formed in a zonal shape wide in width or a line shape narrow in width by stamping out or cutting the board. Otherwise, the slit may be formed by making a cut in the insulating substrate 1 with a thin cutting tool while using a die-cutter, which is customarily termed "Thomson die" onsite in Japan, a pinnacle die or the like instead of stamping. The board is further stamped out in unit of the conductive pattern 3 using a metal mold or the like, whereby a semiconductor device 16 is formed. Now, it is noted that the step of forming the slit 5, and the step of stamping in unit of the conductive pattern may be performed in parallel using a common pair of metal molds.

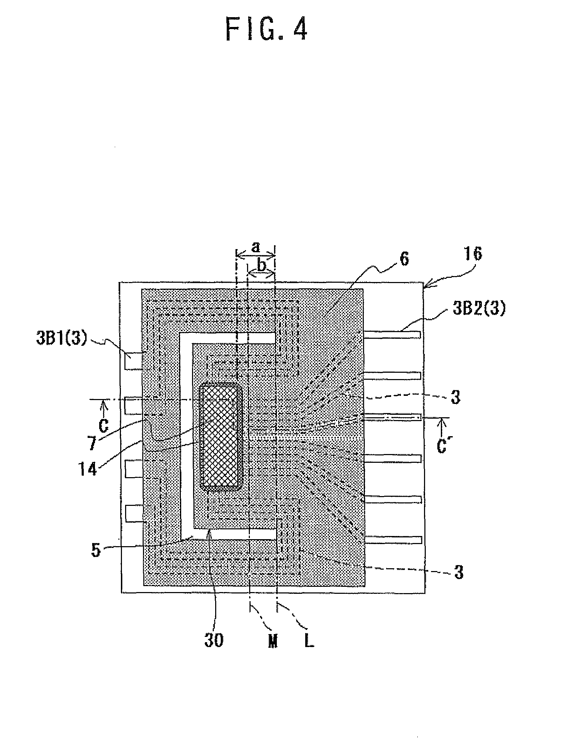

FIG. 4 presents a plane view of the semiconductor device 16 thus formed. FIG. 3D is a sectional view taken along the line C-C' denoted by arrows in FIG. 4.

The slit 5 is formed in the slit-forming region so as to surround the semiconductor 7 while partially leaving surrounding areas thereof. For example, as in the example shown in the drawing, the slit 5 is formed in a horseshoe shape so as to surround three sides of the semiconductor 7 having a quadrangular shape in outward appearance, whereby the semiconductor-mounting part 30 is provided.

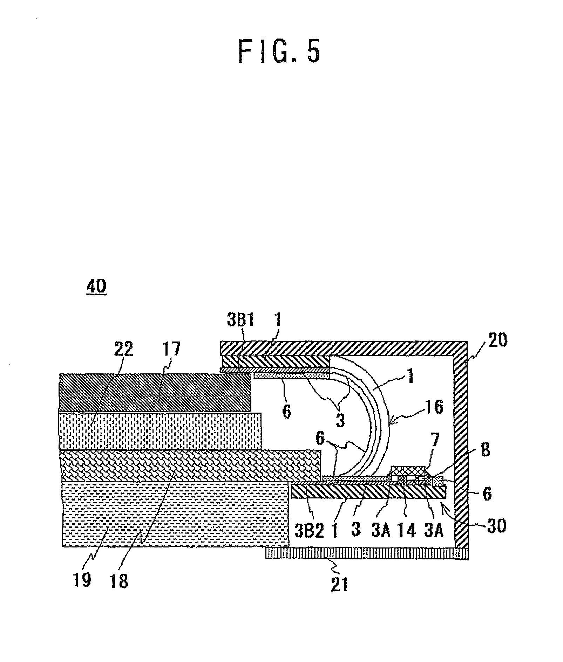

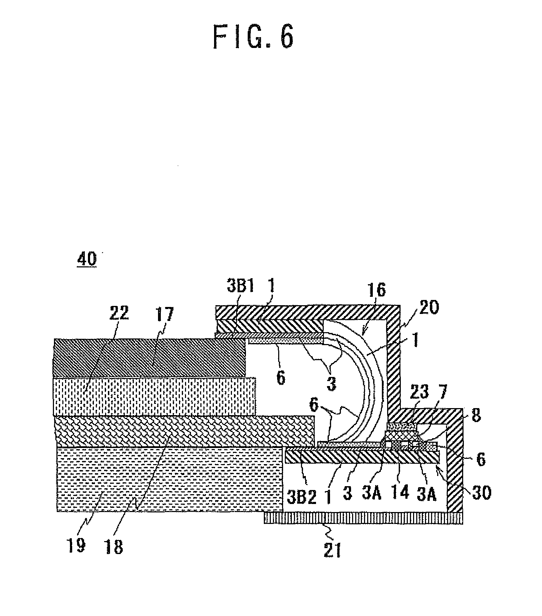

The semiconductor device 16 formed as described above is assembled and used as shown in FIGs. 5 and 6, and included in a display device 40. The display device 40 shown here uses a backlight 22, a quadrilateral glass substrate 18, and a quadrilateral display glass 19, which are stacked in turn. In addition, a printed wiring board 17 for supplying a power source and a signal is arranged therein.

When the semiconductor device 16 is assembled to the display device 40, the following steps are taken: curving the semiconductor device 16 in a bending zone b between a straight line L (see FIG. 4) going through two opposite ends of the slit 5 and across the insulating substrate and a straight line M parallel therewith; folding the insulating substrate 1 so that the front face comes inside except the semiconductor-holding part 30; connecting the second external-connection terminal portion 3B2 of the conductive pattern 3 with the glass substrate 18; and connecting the other first external-connection terminal portion 3B1 with the printed wiring board 17. At this time, the slit 5 is in existence, and therefore the semiconductor-holding part 30 is not turned back, but left extending straight, and juts the semiconductor 7 mounted on the flexible printed wiring board 12 from the rear face of the insulating substrate 1 outwardly. In this way, a plurality of semiconductor devices 16 are joined to adequate sides of the quadrilaterals of the glass substrate 18 and display glass 19.

The printed wiring board 17 used in this example has power-source and signal supplying wires (not shown) provided thereon. The wires can be enlarged in area, and therefore the electrical resistances can be reduced. The power-source and signal supplying wires are connected with a plurality of semiconductor devices 16 in parallel, and the display device 40 is large in size. On that account, even when the number of semiconductor devices 16 so connected is increased, the semiconductor devices 16 individually accept power source and signal supplies through the power-source and signal supplying wires formed on the printed wiring board 17, and the voltage drop arises slightly. Therefore, the semiconductors are stabilized in operation, whereby the display quality can be enhanced.

In addition, according to the assembling method as shown in FIG. 5, the mounted semiconductor 7 juts from the rear face of the insulating substrate 1 by itself. This allows the heat from the semiconductor 7 to be transferred to the ambient air, and further to the first and second housing members 20 and 21, which are formed from metal with a good thermal conductivity or the like, whereby the heat from the semiconductor 7 can be dissipated efficiently. As a result, the semiconductor can be stabilized in operation, whereby the quality of display can be enhanced. For instance, a method used in a case that the frame edge having a somewhat larger area is allowed than a method using a conventional semiconductor device as shown in FIG. 16 can achieve a better heat dissipation efficiency in comparison to the conventional method shown with reference to FIG. 16.

Meanwhile, according to another assembling method as shown in FIG. 6, the mounted semiconductor 7 juts from the rear face of the insulating substrate 1 by itself, and the semiconductor 7 is glued through a high-heat-conductive material 23 to the first housing member 20 formed from e.g. metal having a good thermal conductivity. Assembling a semiconductor device in this way, heat from the semiconductor 7 is conducted through the high-heat-conductive material 23 to the first housing member 20, and to the second housing member 21 located farther than it efficiently, and then efficiently dissipated from there, and thus the temperature of the semiconductor 7 can be reduced. Hence, the semiconductor can be stabilized in operation, whereby the quality of display can be increased. For instance, a method used in a case that the frame edge having a somewhat larger area is allowed than the method using a conventional semiconductor device as shown in FIG. 16 can achieve a better heat dissipation efficiency in comparison to the method shown with reference to FIG. 5.

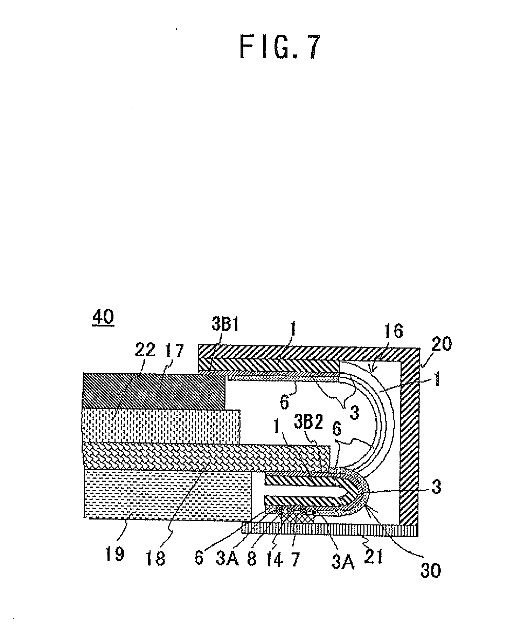

The semiconductor device 16 shown in FIG. 4, which is formed according to steps shown in FIG. 3, can be used in a form that it is assembled to the display device 40 as shown in FIG. 7. Specifically, the following steps are taken: curving the semiconductor device in a bending zone b between a straight line L going through two opposite ends of the slit 5 and across the insulating substrate 1 and a straight line M parallel with it thereby to curve and fold the insulative substrate 1 so that the front face comes inside as shown in FIG. 7; connecting the second external-connection terminal portion 3B2 of the conductive pattern 3 with the glass substrate 18; and connecting the first external-connection terminal portion 3B1 with the printed wiring board 17. At this time, the slit 5 is in existence, and therefore the semiconductor-holding part 30 is not turned back, and juts the semiconductor 7 mounted on the flexible printed wiring board 12 from the rear face of the insulating substrate 1 outwardly. In this case, in order to ensure the bending zone b, the straight line L going through the two opposite ends of the slit 5 and across the insulating substrate is spaced away from the semiconductor 7 by a predetermined distance a. Thus, a plurality of such semiconductor devices 16 are joined to each of adequate sides of the quadrilaterals of the glass substrate 18 and display glass 19.

Thereafter in this example, the semiconductor-holding part 30 is not left extending straight as in the examples shown in FIGS. 5 an 6, but turned back by being curved in the bending zone b so that the rear face comes inside, whereby the top face of the semiconductor 7 abuts on the second housing member 21 by a repulsion force that the insulating substrate 1 has as shown in FIG. 7.

Assembling a semiconductor device in this way, heat from the semiconductor 7 is conducted to the second housing member 21 in contact therewith and to the first housing member 20 located farther than it efficiently, and then efficiently dissipated from there. Therefore, the temperature of the semiconductor 7 can be reduced, and the semiconductor 7 can be stabilized in operation, whereby the quality of display of the display device 40 can be made better. This means is a method used, for example, in a case that the frame edge area of the display device 40 must be equal to the frame edge area according to the method using a conventional semiconductor device as shown in FIG. 16, which can achieve a better heat dissipation efficiency in comparison to the method shown in FIG. 5.

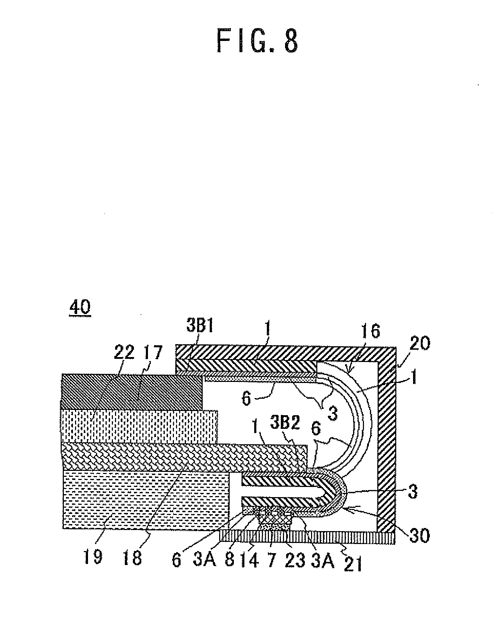

In addition, the semiconductor device 16 shown in FIG. 4 can be used in a form that it is assembled to a display device 40 as shown in FIG. 8. Also, in this example the following steps are taken: curving the semiconductor device 16 in a bending zone b thereby fold the insulating substrate 1 so that the front face comes inside except the semiconductor-holding part 30; connecting the second external-connection terminal portion 3B2 of the conductive pattern 3 with the glass substrate 18; and connecting the first external-connection terminal portion 3B1 with the printed wiring board 17. Thus, a plurality of such semiconductor devices 16 are joined to each of adequate sides of the quadrilaterals of the glass substrate 18 and display glass 19.

Likewise, the semiconductor-holding part 30 is thereafter turned back by being curved in the bending zone b so that the rear face comes inside. However, in the example shown in FIG. 8, the semiconductor 7 is not made to abut on the second housing member 21 by a repulsion force that the insulating substrate 1 has; a high-heat-conductive material 23 is put and glued to between the semiconductor 7 and the second housing member 21 made of e.g. metal having a good thermal conductivity. Using e.g. a heat-dissipating grease exhibiting no adherability for the high-heat-conductive material used here, the top face of the semiconductor 7 may be urged by the repulsion force that the insulating substrate 1 has toward the second housing member 21 through the high-heat-conductive material 23.

By assembling a semiconductor device in this way, heat from the semiconductor 7 can be conducted through the high-heat-conductive material 23 to the second housing member 21 and to the first housing member 20 located farther than it efficiently. Because of using the high-heat-conductive material 23, this method enables more efficient heat dissipation in comparison to the method shown by FIG. 7.
Consequently, the temperature of the semiconductor 7 can be lowered further. Hence, the semiconductor can be stabilized in operation, whereby the quality of display of the display device 40 can be enhanced.

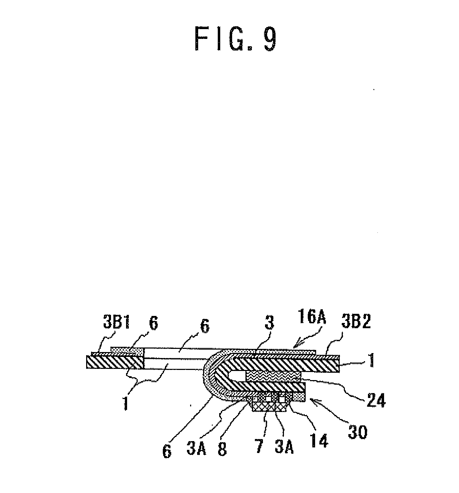

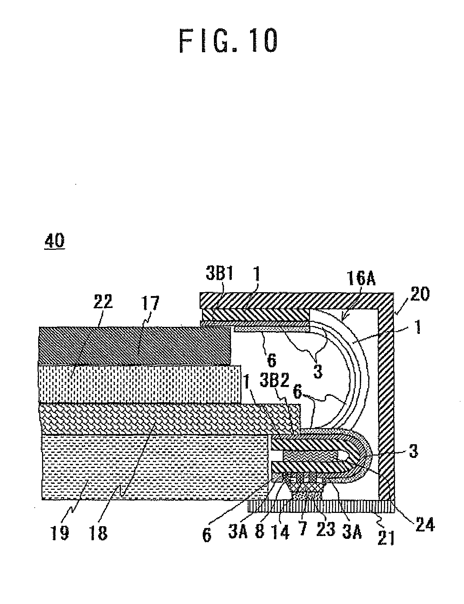

Unlike in comparison to the assembling method, which will be described later with reference to FIGs. 9 and 10, the adhesive 24 is not used according to this method, and therefore the cost can be reduced. In addition, as the tendency of the heat to conduct to the glass substrate 18 can be reduced, the disturbance of display, which would be caused by heat, can be prevented. Also, the influence of a mechanical stress caused by the difference of the coefficient of thermal expansion can be prevented.

Meanwhile, the semiconductor device 16 shown in FIG. 4 can be arranged to form the semiconductor device 16A by curving, in the bending zone b, and turning back the semiconductor-holding part 30 so that the rear face comes inside, followed by gluing between opposing portions of the insulating substrate 1 thus arranged with an adhesive 24 as shown in FIG. 9. The semiconductor device 16A can be assembled to the display device 40 and used in this form, as shown in FIG. 10.

According to the assembling method shown by FIG. 10, a high-heat-conductive material 23 is put and glued to between the semiconductor 7 and the second housing member 21 made of e.g. metal having a good thermal conductivity. By assembling a semiconductor device in this way, heat from the semiconductor 7 can be conducted through the high-heat-conductive material 23 to the second housing member 21 and to the first housing member 20 located farther than it efficiently, and therefore the heat is dissipated from there efficiently. On that account, the temperature of the semiconductor 7 can be lowered, and the semiconductor can be stabilized in operation, whereby the quality of display of the display device 40 can be enhanced. This means is a method used, for example, in a case that the frame edge area of the display device 40 must be equal to the frame edge area according to the method using a conventional semiconductor device as shown in FIG. 16, which can achieve a heat dissipation efficiency better than that attained by the method shown by FIG. 5 and comparable to that accomplished by the method shown by FIG. 6.

Meanwhile, in a plasma display (PDP) device, a semiconductor device having a semiconductor mounted on a film-carrier tape is used as a semiconductor device for activation on both source and gate sides in general. However, a semiconductor device with a semiconductor mounted on a flexible printed wiring board is not used. This is because a plasma display device harnesses a discharge phenomenon to display, and consumes a larger quantity of electric power, and is increased in the heat generation by a semiconductor mounted on a semiconductor device, and therefore it is required to use a semiconductor device having a better heat dissipation efficiency; when a semiconductor device using a film-carrier tape is used in a form that the semiconductor device is curved and folded toward the backside opposite to the display side, a semiconductor mounted thereon is located outwardly of the curve, and thus the heat dissipation efficiency can be increased readily.

In contrast, a conventional semiconductor device having a semiconductor mounted on a flexible printed wiring board, in which the semiconductor is located inwardly of the curve as shown in FIG. 16, is inefficient in heat dissipation. On this account, such semiconductor devices have not been used for both source and gate sides of a plasma display device. However, a semiconductor device which achieves a good heat dissipation efficiency as the one according to the invention can be used for source and gate sides of a plasma display device.

Again in the above example, the semiconductor device 16 shown in FIG. 4 is formed by: connecting the semiconductor 7 with the semiconductor-connecting terminal portion 3A of the conductive pattern 3 formed on the front face of the flexible insulating substrate 1 thereby to mount the semiconductor 7 on the flexible printed wiring board 12; subsequently forming a slit 5 of e.g. a horseshoe shape in the insulating substrate 1 so as to surround the semiconductor 7 while partially leaving surrounding areas thereof thereby to provide the semiconductor-holding part 30; and after or in parallel with the slit formation, stamping out the flexible printed wiring board 12 in unit of the conductive pattern.

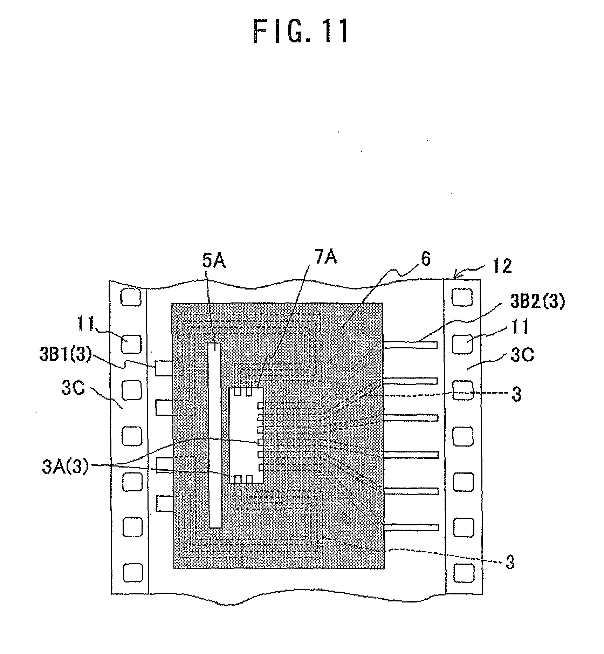

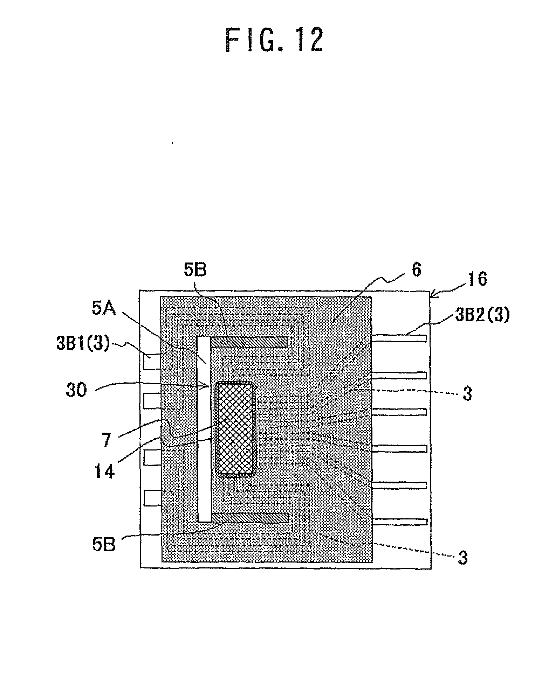

However, the semiconductor device 16 may be formed as shown in FIG. 12 by the following steps. First, while being conveyed with perforations 11 and positioned in turn, the flexible printed wiring board 12 shown in FIG. 2 is stamped out by a pair of metal molds composed of a punch and a die, whereby e.g. a first cut 5A extending straight in a direction of length of the flexible printed wiring board 12 is provided in a region for forming a slit 5 later in the insulating substrate 1, as shown in FIG. 11.

Then, the semiconductor 7 is connected with the semiconductor-connecting terminal portion 3A, and mounted on the flexible printed wiring board 12 and subsequently, a second cut 5B connecting the first cut 5A is provided in the insulating substrate 1 as shown by the hatching in FIG. 12, whereby a slit 5 of e.g. a horseshoe shape is formed so as to surround the semiconductor 7 while partially leaving surrounding areas thereof, and thus the semiconductor-holding part 30 is provided. After or in parallel with the slit formation, the flexible printed wiring board 12 is stamped out in unit of the conductive pattern.

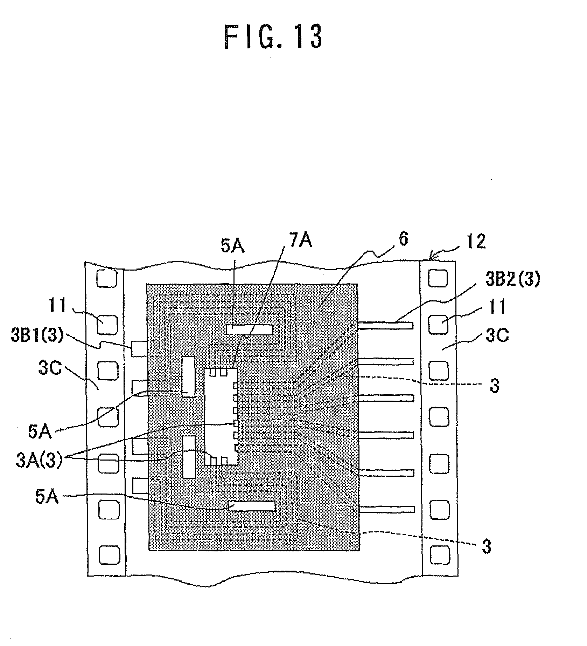

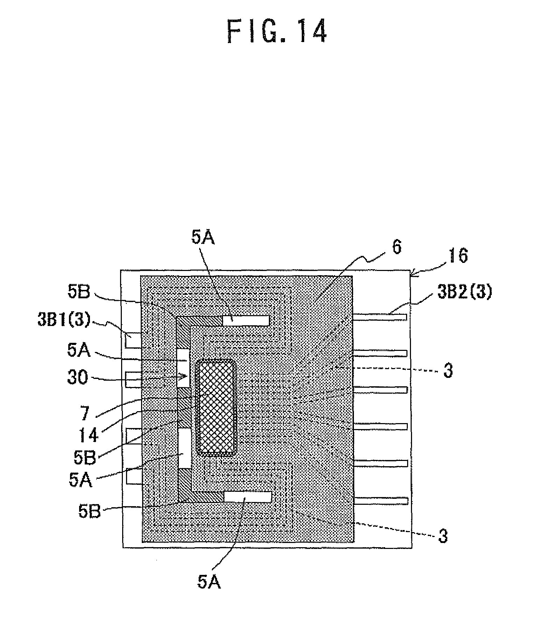

The number of places where the cut 5A is provided is not limited to one. The semiconductor-holding part 30 may be provided by: forming the cut 5A in more than one place in the region for forming the slit 5 as shown in FIG. 13; mounting a semiconductor 7; and providing second cuts 5B so that they connect with the first cuts 5A to make a continuous form, whereby the slit 5 of e.g. a horseshoe shape is formed so as to surround the semiconductor 7 while partially leaving surrounding areas thereof, as shown by the hatching in FIG. 14.

While in the examples shown in FIGs. 11 to 14, the second cuts 5B are provided to connect with one or more first cuts 5A, the second cut 5B larger than the first cut 5A may be provided so that the second cut 5B is superposed on the first cut 5A in position and include the first cut 5A. In addition, the first and second cuts 5A and 5B may be formed in a zonal shape wide in width or a line shape narrow in width. Otherwise, first and second cuts may be formed by making cuts in the insulating substrate 1 with a thin cutting tool while using a die-cutter, which is customarily termed "Thomson die" onsite in Japan, a pinnacle die or the like instead of stamping.

Meanwhile, although mounting the semiconductor 7 on the flexible printed wiring board 12 is performed while conveying the flexible printed wiring board 12 with the perforations 11 and concurrently positioning in turn, at this time a tension is applied to the flexible printed wiring board 12 in order to ensure the flatness thereof. Consequently, a stress produced by the tension is imposed on the semiconductor-mounting region 7A, which brings on the problem that the inter-terminal pitch of the semiconductor-connecting terminal portions 3A is influenced, and the alignment with gold bumps 8 provided on the semiconductor 7 is affected negatively.

Hence, forming the first cut 5A in the flexible printed wiring board 12 before mounting the semiconductor 7 as in the examples shown in FIGs. 11 to 14, it can be made difficult for a stress resulting from the tension to transfer to the semiconductor-mounting region 7A, and therefore the alignment between the semiconductor-connecting terminal portions 3A and gold bumps 8 provided on the semiconductor 7 can be performed readily and precisely.

### INDUSTRIAL APPLICABILITY

The invention is applicable to a semiconductor device and its manufacturing method. Also, it is applicable to a display device mounted with such semiconductor device and its manufacturing method.

## Claims

1. A semiconductor device comprising:
a flexible printed wiring board, having a flexible insulating substrate, and
a conductive pattern formed on a front face of the insulating substrate, and provided with a semiconductor-connecting terminal portion, and first and second external-connection terminal portions located on opposite sides of the semiconductor-connecting terminal portion;
a semiconductor connected with the semiconductor-connecting terminal portion of the conductive pattern and then mounted on the printed wiring board;
a slit formed in the insulating substrate so as to surround the semiconductor while partially leaving surrounding areas thereof; and
a semiconductor-holding part provided by forming the slit,
wherein the slit is formed so that the mounted semiconductor juts outwardly from a rear face of the insulating substrate when folding the insulating substrate so that the front face thereof comes inside except the semiconductor-holding part, and connecting the first and second external-connection terminal portions with other components respectively.

2. The semiconductor device according to Claim 1, wherein the slit is formed in a horseshoe shape so as to surround three sides of the semiconductor having a quadrangular shape in outward appearance.

3. The semiconductor device according to Claim 1, wherein the insulating substrate can be curved in a bending zone between a straight line going through two opposite ends of the slit and across the insulating substrate and a straight line parallel therewith so that the rear face comes inside, thereby to turn back the semiconductor-holding part, and
in order to make possible to so curve the insulating substrate to turn back the semiconductor-holding part, the straight line going through the opposite ends of the slit and across the insulating substrate is spaced away from the semiconductor by a predetermined distance.

4. The semiconductor device according to Claim 2, wherein the insulating substrate can be curved in a bending zone between a straight line going through two opposite ends of the slit and across the insulating substrate and a straight line parallel therewith so that the rear face comes inside, thereby to turn back the semiconductor-holding part, and
in order to make possible to so curve the insulating substrate to turn back the semiconductor-holding part, the straight line going through the opposite ends of the slit and across the insulating substrate is spaced away from the semiconductor by a predetermined distance.

5. The semiconductor device according to Claim 3, wherein the semiconductor-holding part is turned back on the bending zone so that its rear face comes inside, and
opposing portions of the insulating substrate thus arranged are stuck together.

6. A display device comprising the semiconductor device according to any one of Claims 1 to 5,
wherein the semiconductor device is mounted by curving the insulating substrate in a bending zone between a straight line going through two opposite ends of the slit and across the insulating substrate and a straight line parallel therewith, to fold the insulating substrate so that its front face comes inside except the semiconductor-holding part, and connecting the first and second external-connection terminal portions of the conductive pattern with other components.

7. The display device according to Claim 6, wherein the semiconductor is glued to a housing member through a high-heat-conductive material.

8. The display device according to Claim 6, wherein the semiconductor-holding part is turned back by being curved in the bending zone so that its rear face comes inside.

9. The display device according to Claim 7, wherein the semiconductor-holding part is turned back by being curved in the bending zone so that its rear face comes inside.

10. The display device according to Claim 8 or 9, wherein the semiconductor-holding part is turned back so that its rear face comes inside, and
opposing portions of the insulative substrate thus arranged are stuck together.

11. A method of manufacturing a semiconductor device, comprising the steps of:
mounting a semiconductor between first and second external-connection terminal portions provided in a conductive pattern formed on a front face of a flexible insulating substrate of a flexible printed wiring board by connecting with a semiconductor-connecting terminal portion of the conductive pattern on the flexible printed wiring board; and
then, forming a slit in the insulating substrate so as to surround the semiconductor while partially leaving surrounding areas thereof thereby to provide a semiconductor-holding part, in which the slit is formed so that the mounted semiconductor juts outwardly from a rear face of the insulating substrate when folding the insulating substrate except the semiconductor-holding part so that its front face comes inside, and connecting the first and second external-connection terminal portions with other components respectively; and
after or in parallel with the slit formation, stamping out the flexible printed wiring board in unit of the conductive pattern.

12. The method of manufacturing a semiconductor device according to Claim 11, wherein the semiconductor-holding part is turned back on a bending zone between a straight line going through two opposite ends of the slit and across the insulating substrate, and a straight line parallel therewith so that its rear face comes inside.

13. A method of manufacturing a semiconductor device comprising the steps of:
providing a first cut in a flexible insulating substrate of a flexible printed wiring board with a conductive pattern formed on a front face of the insulating substrate and provided with first and second external-connection terminal portions in order to prevent a tension applied to the flexible printed wiring board from affecting an inter-terminal pitch of a semiconductor-connecting terminal portion of the conductive pattern when conveying the flexible printed wiring board;
then, mounting a semiconductor between the first and second external-connection terminal portions on the flexible printed wiring board by connecting with the semiconductor-connecting terminal portion;
subsequently, providing a second cut including or connecting with the first cut to form a slit in the insulating substrate so as to surround the semiconductor while partially leaving surrounding areas thereof and to provide a semiconductor-holding part, in which the slit is formed so that the mounted semiconductor juts outwardly from a rear face of the insulating substrate when folding the insulating substrate except the semiconductor-holding part so that its front face comes inside, and connecting the first and second external-connection terminal portions with other components respectively; and
after or in parallel with the slit formation, stamping out the flexible printed wiring board in unit of the conductive pattern.

14. The method of manufacturing a semiconductor device according to Claim 13, wherein the semiconductor-holding part is turned back on a bending zone between a straight line going through two opposite ends of the slit and across the insulating substrate, and a straight line parallel therewith so that its rear face comes inside.

15. A method of manufacturing a display device, comprising the steps of:
forming a semiconductor device on the manufacturing method according to any one of Claims 11 to 14, and
then, folding the insulating substrate on a bending zone between a straight line going through two opposite ends of the slit and across the insulating substrate, and a straight line parallel therewith so that its front face comes inside except the semiconductor-holding part, and
connecting the first and second external-connection terminal portions of the conductive pattern with other components.

16. The method of manufacturing a display device according to Claim 15, wherein the semiconductor is glued to a housing member through a high-heat-conductive material.

17. The method of manufacturing a display device according to Claim 15, the semiconductor-holding part is turned back by being curved in the bending zone so that its rear face comes inside.

18. The method of manufacturing a display device according to Claim 16, the semiconductor-holding part is turned back by being curved in the bending zone so that its rear face comes inside.
